# EUROPEAN PATENT SPECIFICATION

(11) **EP 3 997 518 B1**
(45) Date of publication and mention of the grant of the patent: **29.07.2026**
(21) Application number: 20731081.4
(22) Date of filing: 09.06.2020
(51) Int. Cl.: G03F 7/00, H01S 3/00, H05G 2/00, B23K 26/04, G02B 3/10, H01S 3/038, H01S 3/08, H01S 3/13, H01S 3/223, H01S 3/23, H01S 5/22

(54) **A MEASUREMENT SYSTEM FOR USE WITH A LIGHT AMPLIFICATION CAVITY**
MESSSYSTEM ZUR VERWENDUNG MIT EINEM LICHTVERSTÄRKUNGSHOHLRAUM
SYSTÈME DE MESURE DESTINÉ À ÊTRE UTILISÉ AVEC UNE CAVITÉ D'AMPLIFICATION DE LUMIÈRE

(30) Priority: 11.07.2019 EP 19185779
(43) Date of publication of application: 18.05.2022
(73) Proprietor: ASML Netherlands B.V., 5500 AH Veldhoven (NL); TRUMPF Lasersystems for Semiconductor Manufacturing SE, 71254 Ditzingen (DE)
(72) Inventor: GOKCE, Berkcan, 5500 AH Veldhoven (NL); GANGULY, Vasishta Parthasarathy, 5500 AH Veldhoven (NL); OEMRAWSINGH, Sumant Sukdew Ramanujan, 5500 AH Veldhoven (NL); STRUYCKEN, Alexander Matthijs, 5500 AH Veldhoven (NL); ERHARD, Steffen, Ditzingen (DE); STEINBRÜCK, Torsten, Ditzingen (DE); MÜLLER, Jonathan, Ditzingen (DE)
(74) Representative: ASML Netherlands B.V.
(86) International application number: PCT/EP2020/065943
(87) International publication number: WO 2021/004717

(56) References cited:
- EP-A2- 0 390 013
- US-A- 4 772 122
- US-A1- 2002 057 432
- US-A1- 2011 317 256
- US-A1- 2016 316 551
- US-A1- 2017 085 054

## Description

### CROSS-REFERENCE TO RELATED APPLICATIONS

This application claims priority of EP application 19185779.6 which was filed on July 11, 2019.

### FIELD

The present invention relates to a measurement system for use with a light amplification cavity. The light amplification cavity may form part of a laser system, which may in turn form part of a laser produced plasma (LPP) radiation source. The LPP radiation source may produce extreme ultraviolet (EUV) radiation and may form part of a lithography system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV radiation for a lithographic apparatus may be produced by a laser produced plasma (LPP) radiation source. Within an LPP radiation source, a laser beam may be used to irradiate fuel droplets so as to produce a plasma which will emit EUV radiation. US2016316551A1 relates to a laser apparatus and an EUV light generation system including the laser apparatus. US2002057432A1 relates to a beam detection system for use with an illumination system. US2017/0085054 A1 relates to a drive laser arrangement including a beam source for generating a laser beam and an amplifier arrangement for amplifying the laser beam.

### SUMMARY

The present invention is defined in the appended independent claim 1. Dependent claims 2-14 define preferred embodiments of the present invention. According to a first exemplary aspect there is provided a measurement system for use with a light amplification cavity, the measurement system comprising: an input optical element for receiving an input radiation beam and directing: a first portion of the input radiation beam along a first optical path; and a second portion of the input radiation beam along a second optical path; an imaging system arranged on the first optical path and configured to form in an image plane: first and second images of the first portion of the input radiation beam, the first and second images being of two different planes along the first optical path; and a detector disposed in the image plane and operable to detect the first and second images.

The second optical path lead to (and may form an input optical path for) a light amplification cavity. Therefore, in use, the input optical element can receive an input radiation beam and direct the second portion of the radiation beam to such a light amplification cavity whilst also directing the first portion of the input radiation beam along the first optical path. The measurement system according to the first exemplary aspect is advantageous since it allows for the position and direction of an input radiation beam (which is to be input to a light amplification cavity) to be determined. In particular, as discussed further below, it allows for such measurements to be used as part of a feedback alignment process for aligning an input radiation beam with a light amplification cavity.

It will be appreciated that a position and/or direction of the first portion of the input radiation beam is indicative of, or related to, the position and/or direction of the second portion of the input radiation beam (which may be input for a light amplification cavity). For example, the input optical element may be a beam splitter.

Each of the first and second images can provide information relating to a position of the input radiation beam.

It will be appreciated that the two different planes along the first optical path which are imaged onto the detector are axially spaced apart on the first optical path. Here, an axial direction should be understood to mean a direction along an optical path along which radiation or light propagates. Since the first and second images are of two different planes along the first optical path, in combination the first and second images can provide information relating to a direction of the input radiation beam.

The measurement system may further comprise steering optics. The steering optics may be arranged to receive the input radiation beam and to direct the input radiation beam to the input optical element. The steering optics may comprise an adjustment mechanism operable to control a direction and/or position of the input radiation beam at the input optical element.

Advantageously, such an arrangement allows a position and/or direction of a radiation beam that is input into a light amplification cavity to be optimized. The adjustment mechanism of the steering optics can be used to control a direction and/or position of the input radiation beam at the input optical element. Simultaneously, the position and/or direction of the radiation beam can be monitored using the first and second images that are formed on the detector. A user can therefore use the adjustment mechanism of the steering optics to align the input radiation beam to a light amplification cavity. For example, the user may use the adjustment mechanism of the steering optics to control the position and/or direction of the input radiation beam until the first and second images have desired positions and/or shapes.

It will be appreciated that the steering optics may comprise any system of optics that allows a direction and/or position of the input radiation beam to be controlled. In one embodiment, the steering optics may comprise two movable mirrors arranged to receive the input radiation beam sequentially. For example, each of the movable mirrors may be rotatable and/or translatable. In one embodiment, each of the movable mirrors may be rotatable about two mutually orthogonal axes.

The measurement system may further comprise a display for displaying the images of the input radiation beam in two different (axially spaced) planes along the first optical path. This may provide a visual guide for a user performing an alignment process.

The measurement system may further comprise a memory operable to store information about a nominal direction and/or nominal position of an input radiation beam.

For example, the memory may store information about the first and second images that would be formed when the input radiation beam is pointing in the nominal direction and/or is at the nominal position. The memory may store the first and second images that would be formed when the input radiation beam is pointing in the nominal direction and/or is at the nominal position. Additionally or alternatively, the memory may store information about these first and second images such as, for example, central positions thereof.

The measurement system may further comprise a feedback loop operable to use the adjustment mechanism of the steering optics to control the position and/or direction of the input radiation beam until the position and/or direction of the input radiation beam substantially coincide with a nominal direction and/or nominal position of an input radiation beam.

Such an arrangement may, advantageously, allow an alignment process for a light amplification cavity to be substantially automated.

The display may be further operable to display at least one visual marker for each of the first and second images, the at least one visual marker being indicative of a position and/or shape of that one of the first and second images when the position and/or direction of the input radiation beam substantially coincides with a nominal direction and/or nominal position of an input radiation beam.

For example, a marker (for example a cross) may be displayed on the display to indicate a desired or nominal position of a center of each of the first and second images. A user can use the adjustment mechanism of the steering optics to control the position and/or direction of the input radiation beam until the center of each of the first and second images coincides with one of said markers.

It will be appreciated that the imaging system comprises any system of optics that is operable to split the radiation beam into two parts and form the first and second images from said two parts.

The imaging system comprises a lens having two surfaces which are each provided with a reflective coating, at least one of said two surfaces being curved, and wherein the second portion of the input radiation beam is incident on the second lens off-axis and wherein the first and second images are formed from separate portions of the second portion of the input radiation beam, the separate portions experiencing a different number of reflections from the two surfaces.

It will be appreciated that the axis of the lens may be an axis of rotation of the lens. It will be further appreciated that a radiation beam being incident on the second lens off-axis is intended to mean that the radiation beam is incident on a position which is at a non-zero distance from the axis of the second lens.

With such an arrangement, a first transmitted portion of the radiation incident on the lens is transmitted at both the first and the second surfaces of the lens. If the reflectivity of the coating on the two surfaces is R then the fraction of the incident radiation that forms this first transmitted portion is given by (1-R)². The first transmitted portion may be referred to as the 0^{th} order beam.

Furthermore, a second transmitted portion of the radiation incident on the lens is transmitted at the first surface, internally reflected at the second surface, internally reflected at the first surface and then transmitted at the second surface. The fraction of the incident radiation that forms this second transmitted portion is given by R²(1-R)². The second transmitted portion may be referred to as the 1^{st} order beam.

Since the second portion of the input radiation beam is incident on the lens off-axis (i.e. at a position which is at some non-zero distance from an axis of the lens), the first and second transmitted portions are spatially separated and therefore will be incident on different parts of the detector.

Furthermore, the first and second transmitted portions pass through different paths in the lens. In particular, the second transmitted portion experiences an additional two reflections from the two surfaces of the lens (at least one of which is curved). Therefore, in effect, the first and second transmitted portions experience different amounts of optical power. Equivalently, a focal length of the lens is different for the first and second transmitted portions. As a result, in the plane of detector, the first and second transmitted portions are images of the first portion of the input radiation beam from two different planes along the first optical path.

The first image may be formed from a first transmitted portion of the radiation incident on the lens which is transmitted at both the first and the second surfaces of the lens. The second image may be formed from a second transmitted portion of the radiation incident on the lens which is transmitted at the first surface, internally reflected at the second surface, internally reflected at the first surface and then transmitted at the second surface.

The radii of curvature of the first and second surfaces may be such that a diameter of the first image in the image plane is bigger than a diameter of the second image in the image plane.

Since the first transmitted portion (from which the first image is formed) undergoes fewer reflections than the second transmitted portion (from which the second image is formed), the intensity of the first image will be greater than that of the second image. However, if the diameter of the first image in the image plane is bigger than the diameter of the second image in the image plane then the intensity densities of the two images can still be matched (and may also both be matched to the dynamic range of the detector).

The first and second surfaces may have a reflectivity of R and the radii of curvature of the first and second surfaces may be such that the diameter of the first image in the image plane is bigger than the diameter of the second image in the image plane by a factor of R.

The reflectivities of the reflective coatings on the first and second surfaces of the lens and the radii of curvature of the first and second surfaces of the lens may be such that the intensity densities of the two images are substantially matched.

The measurement system may further comprise chromatic optics arranged on the first optical path and configured to split the input radiation beam into at least two wavelength components and to direct said at least two components to different portions of the detector.

For example, the input radiation beam may comprise two different wavelengths of radiation. Said two different wavelengths of radiation may both be directed into the light amplification cavity.

It will be appreciated that each of the at least two wavelength components may be provided with separate steering optics, of the type described above (and comprising separate adjustment mechanisms operable to control a direction and/or position of each of the at least two wavelength components of the input radiation beam.

Each of the at least two wavelength components may be provided with a separate detector and/or display. Alternatively, each of the at least two wavelength components may be detected by (different parts of) a single detector and/or may be displayed on a single display.

First and second spatially separated images are formed by the imaging system. In addition, the chromatic optics are arranged to split each of these further into two portions (having different wavelengths). It will be appreciated that the dichroic optics may split the radiation in different (for example orthogonal) direction to the splitting that is performed by the imaging system. As a result, four images are formed on the detector: first and second images for a first wavelength and first and second images for a second wavelength.

The chromatic optics may comprise an optical element comprising first and second opposed surfaces; the first and second opposed surfaces may be arranged at a non-zero angle to each other. The first surface may be provided with a coating that is reflective for a first wavelength of radiation and transmissive for a second wavelength of radiation. The second surface may be reflective for the second wavelength of radiation.

Such an optical element can receive an input radiation beam comprising a mixture of the first wavelength and the second wavelength (for example incident on the first surface at a non-zero angle of incidence) and direct the first and second wavelength components to separate locations.

Such an optical element is particularly advantageous since it can perform multiple functions and therefore save space. An alternative chromatic optics may, for example, comprise two dichromic mirrors, a beam splitter and an optical component to ensure that the two wavelength components travel an equal optical path length.

The second surface of the optical element may be provided with a coating that is reflective for the second wavelength of radiation. The coating on the second surface of the optical element may also be transmissive for the first wavelength of radiation.

According to a second exemplary aspect there is provided a system comprising: an amplification cavity; the measurement system of any preceding claim, wherein the amplification cavity is arranged along the second optical path.

With such an arrangement, the second portion of the input radiation beam (which is directed along the second optical path by the input optical element) is received by the amplification cavity. The amplification cavity is arranged to amplify the second portion of the input radiation beam.

In some embodiments, the system may comprise two measurement systems according to the first exemplary aspect, for example one at each end of the amplification cavity. The amplification cavity may be arranged along the second optical path of each of the two measurement systems according to the first exemplary aspect such that radiation can be received from each of the two input optical elements.

The amplification cavity may comprise: two coaxial generally cylindrical electrodes; a gain medium provided in a generally tube shaped cavity defined between the two coaxial generally cylindrical electrodes; and a generally annular mirror disposed at each end of the cavity.

Each of the mirrors may be provided with an aperture to allow a laser beam to pass into and out of the cavity. Although generally annular (and therefore generally closing the generally tube shaped cavity defined between the two coaxial generally cylindrical electrodes), the shape of the two mirrors (and the initial position and direction of the input laser beam propagating along the second optical path) are arranged such that as the laser beam passes back and forth between the two mirrors its trajectory also processes azimuthally around an axis of the amplification cavity. For example, one of the mirrors may be generally conical in shape and the other mirror may be generally helical.

The system may further comprise: a seed laser operable to output a seed laser beam, the input optical element being arranged receive the seed laser beam as the input radiation beam.

In some embodiments, the system may comprise two seed lasers, each operable to output a seed laser beam. The input optical element of least one measurement systems according to the first exemplary aspect may be arranged to receive the seed laser beam of each of the two seed lasers as an input radiation beam.

According to a third exemplary aspect there is provided a laser system comprising the system according to the second exemplary aspect.

The laser system may further comprise an amplification chain. The amplification chain may comprise a chain of resonators. The laser system may form part of a laser produced plasma radiation source.

According to a fourth exemplary aspect there is provided a laser produced plasma radiation source comprising: a fuel emitter operable to produce a fuel target at a plasma formation region; and the laser system according to the third exemplary aspect arranged to irradiate the fuel target at the plasma formation region so as to produce a plasma.

According to a fifth exemplary aspect there is provided a lithographic system comprising: the laser produced plasma radiation source according to the fourth exemplary aspect; and a lithographic apparatus.

According to a sixth exemplary aspect there is provided a method for aligning an input radiation beam with an amplification cavity, the method comprising: receiving the input radiation beam; directing a first portion of the input radiation beam along a first optical path; and directing a second portion of the input radiation beam along a second optical path for receipt by the amplification cavity; forming in an image plane: first and second images of the first portion of the input radiation beam, the first and second images being of two different planes along the first optical path; and detecting the first and second images in the image plane.

The method according to the sixth exemplary aspect may be implemented using the system according to the first exemplary aspect.

The method may further comprise controlling a direction and/or position of the input radiation beam.

For example, the direction and/or position of the input radiation beam can be controlled whilst simultaneously the position and/or direction of the radiation beam can be monitored using the first and second images.

The method may further comprise: comparing at least one characteristic of each of the first and second images to a nominal value of said at least one characteristic, said nominal value being indicative of a nominal direction and/or nominal position of the input radiation beam.

The method may further comprise controlling the position and/or direction of the input radiation beam until the at least one characteristic of each of the first and second images substantially matches a nominal value of said at least one characteristic.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 shows, schematically, a seed module that may form part of the laser system shown in Figure 1;
- Figure 3 shows a system comprising an amplification cavity that may form part of the seed module shown in Figure 2; a first measurement system; and a second measurement system;
- Figure 3A shows an example of first and second images formed in an image plane in which the detector of the first measurement system shown in Figure 3 is disposed;
- Figure 3B shows an example of four images formed in an image plane in which the detector of the second measurement system shown in Figure 3 is disposed;
- Figure 4 shows a second lens and a detector that form part of the first measurement system and the second measurement system shown in Figure 3:
- Figure 5 shows the first measurement system and the amplification cavity of the system shown in Figure 3 (for ease of understanding some parts of the first measurement system are not shown);
- Figure 6 shows a dichroic wedge that forms part of the second measurement system of the system shown in Figure 3; and
- Figure 7 shows an alternative chromatic optics which the dichroic wedge of Figure 6 can replace, the chromatic optics comprising two dichromic mirrors a beam splitter and an optical component arranged to ensure that two wavelength components travel an equal optical path length.

### DETAILED DESCRIPTION

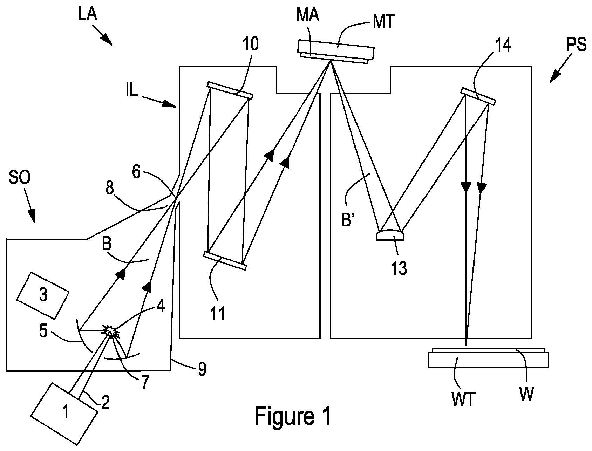

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The laser beam 2 which is incident upon the tin at the plasma formation region 4 may be a pulsed laser beam. The laser beam 2 which is incident upon the tin at the plasma formation region 4 may be referred to as a main laser beam and individual pulses of this laser beam 2 may be referred to as main pulses.

Before the main laser beam 2 is incident upon the tin at the plasma formation region 4, another pre-pulse laser beam may be incident on the tin. The pre-pulse laser beam may act to change a shape of the tin so as to increase the conversion efficiency when the main pulse is (subsequently) incident on the tin.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The laser system 1 may comprise a seed module (which may be referred to as a high power seed module) and an amplification chain. The seed module may be operable to produce the pre-pulse laser beam and the main pulse laser beam. The amplification chain may be operable to receive the pre-pulse laser beam and the main pulse laser beam from the seed module and to increase the power of each of the pre-pulse laser beam and the main pulse laser beam. The amplification chain may comprise a chain of resonators.

The seed module may comprise two seed lasers: a pre-pulse seed laser and a main pulse seed laser. The seed module may further comprise an amplification cavity arranged to amplify each of the pre-pulse laser beam and the main pulse laser beam.

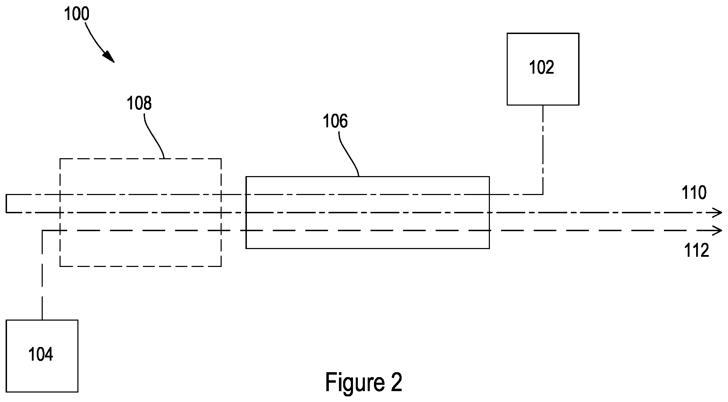

Figure 2 shows, schematically, a seed module 100 that may form part of the laser system 1 shown in Figure 1. The seed module comprises a main pulse seed laser 102, a pre-pulse seed laser 104 and an amplification cavity 106.

The amplification cavity 106 is arranged to amplify the output of each of the main pulse seed laser 102 and the pre-pulse seed laser 104. In the example shown, the output of the main pulse seed laser 102 passes through the amplification cavity 106 twice: first on one direction and then subsequently, following reflection, in the opposite direction before being output as a main pulse laser beam 110. The output of the pre-pulse seed laser 104 passes through the amplification cavity 106 once before being output as a pre-pulse laser beam 112.

Note that although the laser beams which propagate through the amplification cavity 106 are shown spatially separated, this is merely to more clearly distinguish them. As explained further below, in practice, each of the laser beams follow substantially the same trajectory through the amplification cavity 106.

The seed module 100 further comprises an optical diode system 108 which is arranged to prevent, or at least substantially reduce, back reflections being incident on either of the main pulse seed laser 102 or the pre-pulse seed laser 104. Such back reflections being incident on either of the main pulse seed laser 102 or the pre-pulse seed laser 104 would adversely affect the stability of their outputs.

The amplification cavity 106 is of a type comprising two coaxial generally cylindrical electrodes. Between the two electrodes a gain medium (for example C0₂) is provided in a generally tube shaped cavity. At each end of the cavity two generally annular mirrors are provided. Each of the mirrors is provided with an aperture to allow a laser beam to pass into and out of the cavity.

An input laser beam passes through the aperture in the mirror at a first end of the amplification cavity 106. The laser beam then propagates back and forth through the generally tube shaped cavity being reflected by the two mirrors. The shape of the mirrors and the initial position and direction of the input laser beam are arranged such that as the laser beam passes back and forth between the two mirrors its trajectory also processes azimuthally around an axis of the amplification cavity 106. For example, one of the mirrors may be generally conical in shape and the other mirror may be generally helical. Eventually, the laser beam will align (azimuthally) with the aperture in the mirror at the second end of the amplification cavity 106 and the laser beam (now amplified) exits the amplification cavity 106.

Such an amplification cavity 106 is particularly suited for high power applications. However, the quality of the output laser beam from such an amplification cavity 106 is strongly dependent on the initial input trajectory (both the position and direction) of the input laser beam. Therefore, at the point of installation, or after maintenance, it is important for the main pulse seed laser 102 and the pre-pulse seed laser 104 to be aligned, or re-aligned, with the amplification cavity 106.

Some embodiments of the present invention provide a novel measurement system for achieving accurate alignment of a seed laser (for example the main pulse seed laser 102 or the pre-pulse seed laser 104) with an amplification cavity 106.

**In** general, the novel measurement system may be provided at one end of an amplification cavity 106 and may allow accurate alignment of an input seed laser beam with that end of the amplification cavity 106. For arrangements wherein the amplification cavity 106 receives seed laser beams propagating in opposite directions, two novel measurement systems may be provided: one at each end of an amplification cavity 106.

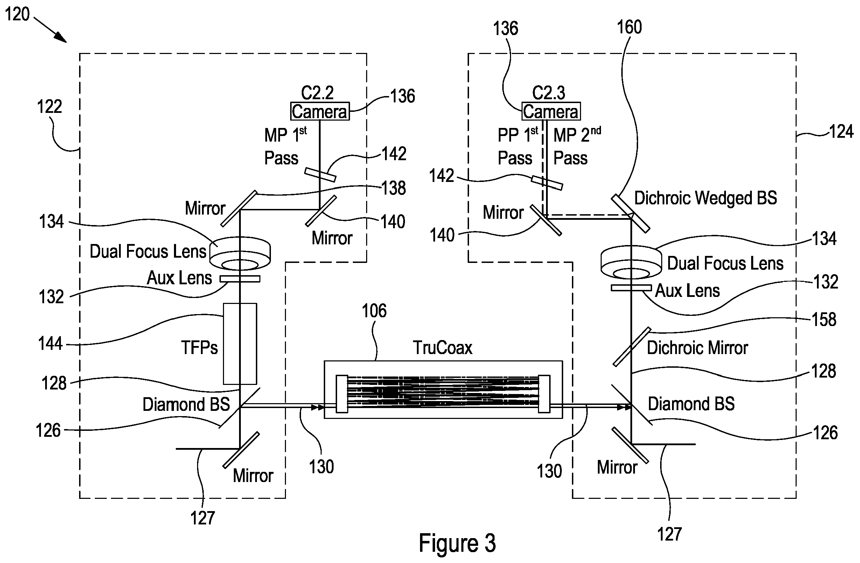

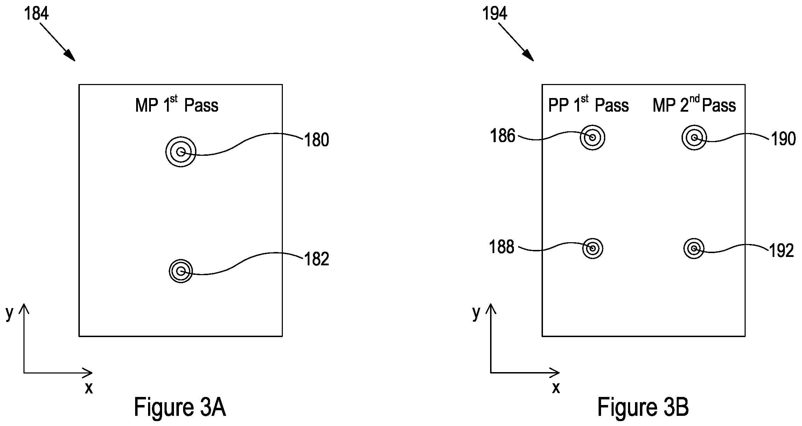

Figure 3 shows a system 120 comprising the amplification cavity 106; a first measurement system 122; and a second measurement system 124.

The first measurement system 122 is provided at an end of the amplification cavity 106 which receives the output of the main pulse seed laser 102 (note that this end is on the left hand side in Figure 3 although it is on the right hand side in Figure 2).

The first measurement system 122 comprises a beam splitter 126. The beam splitter 126 may be considered to be an input optical element for receiving an input radiation beam 127 and directing: a first portion of the input radiation beam along a first optical path; and a second portion of the input radiation beam along a second optical path. In particular, the beam splitter 126 is arranged to receive the output of the main pulse seed laser 102 and to direct: a first portion 128 of the input radiation beam 127 along a first optical path; and a second portion 130 of the input radiation beam 127 along a second optical path (into the amplification cavity 106).

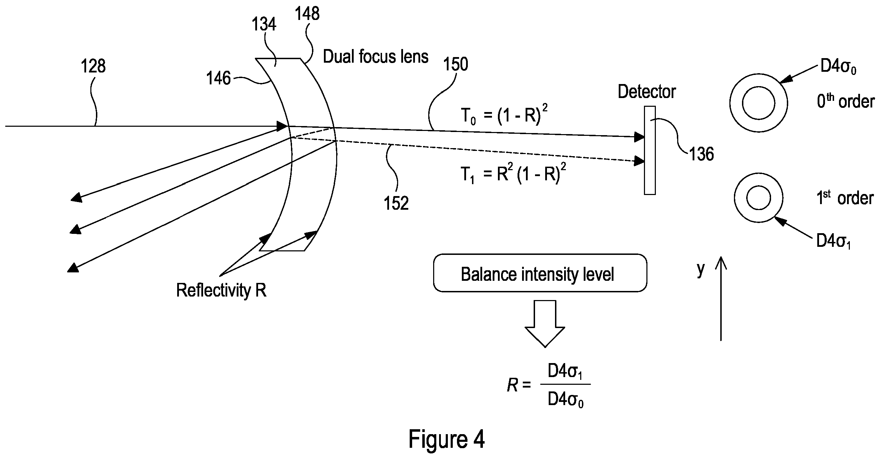

The first measurement system 122 further comprises a first lens 132, a second lens 134 and a detector 136. The first lens 132 and the second lens 134 form an imaging system. In particular, as will be described further below (with reference to Figure 4), first lens 132 and the second lens 134 form an imaging system that is configured to form in a plane of the detector 136: first and second images of the first portion 128 of the input radiation beam 127, the first and second images being of two different planes along the first optical path.

Optionally, two mirrors 138, 140 and a transparent window 142 are provided between the second lens 134 and the detector 136.

The detector 136 may be of the form of a camera and may comprise a two dimensional array of sensing elements. Each sensing element may be operable to detect a different pixel of an image.

Optionally, the first measurement system 122 further comprises a polarizer 144 (for example, comprising one or more thin-film polarizers). The polarizer 144 may be arranged to transmit the first portion 128 of the output of the main pulse seed laser 102 and may be arranged to block any back-reflected portions of the main pulse laser beam 110 and the pre-pulse laser beam 112.

As shown in Figure 4, the second lens 134 comprises two curved surfaces: a first concave surface 146 and a second convex surface 148, which are both provided with a reflective coating. The reflective coating has a reflectivity of R for the radiation of the pre-pulse and main pulse laser beams. Furthermore, the second portion 128 of the input radiation beam 127 is incident on the second lens 134 off-axis (i.e. at a position which is at some non-zero distance from an axis of the second lens 134).

A first transmitted portion 150 of the incident radiation 128 is transmitted at both the first concave surface 146 and the second convex surface 148. The fraction of the incident radiation 128 that forms this first transmitted portion 150 is given by (1-R)². The first transmitted portion 150 may be referred to as the 0^{th} order beam.

A second transmitted portion 152 of the incident radiation 128 is transmitted at the first concave surface 146, reflected at the second convex surface 148, reflected at the first concave surface 146 and then transmitted at the second convex surface 148. The fraction of the incident radiation 128 that forms this second transmitted portion 152 is given by R²(1-R)². The second transmitted portion 152 may be referred to as the 1^{st} order beam.

Since the second portion 128 of the input radiation beam 127 is incident on the second lens 134 off-axis (i.e. at a position which is at some non-zero distance from an axis of the second lens 134), the first and second transmitted portions 150, 152 are spatially separated and therefore will be incident on different parts of the detector 136. The first and second transmitted portions 150, 152 are spatially separated in a direction that is indicated as the y-direction in Figure 4 (and which is into the plane of Figure 3).

Furthermore, the first and second transmitted portions 150, 152 pass through different paths in the second lens 134. In particular, the second transmitted portion 152 experiences an additional two reflections from the two curved surfaces 146, 148 of the second lens 134. In effect, the first and second transmitted portions 150, 152 experience different amounts of optical power. Equivalently, a focal length of the second lens 134 is different for the first and second transmitted portions 150, 152. As a result, in the plane of detector 136, the first and second transmitted portions 150, 152 are images of the first portion 128 of the input radiation beam 127 from two different planes along the first optical path.

Figure 3A shows an example of the first and second images 180, 182 formed in the image plane 184 in which the detector 136 of the first measurement system 122 is disposed. The first image 180 is formed from the first transmitted portion 150 of the second lens 134 of the first measurement system 122. The second image 182 is formed from the second transmitted portion 152 of the second lens 134 of the first measurement system 122. The first and second images 180, 182 are spatially separated in the y-direction.

It will be appreciated that the two different planes along the first optical path which are imaged onto the detector 136 are axially spaced apart on the first optical path. Here, an axial direction should be understood to mean a direction along an optical path along which radiation or light propagates. Since the first and second images 180, 182 are of two different planes along the first optical path, in combination the first and second images 180, 182 can provide information relating to a direction of the input radiation beam 127.

The first measurement system 122 is advantageous since it allows for the position and direction of an input radiation beam 127 (part of which is to be input to an amplification cavity 106) to be determined. It will be appreciated that a position and/or direction of the first portion 128 of the input radiation beam 127 is indicative of, or related to, the position and/or direction of the second portion 130 of the input radiation beam 127 (which is input into the amplification cavity 106).

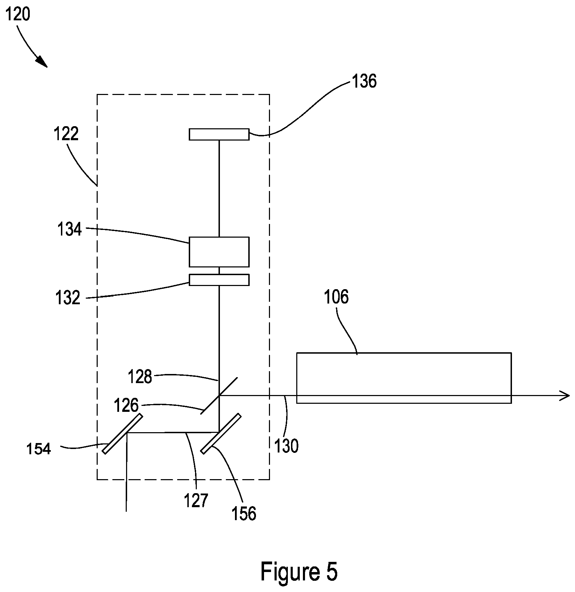

The first measurement system 122 allows for measurements of the position and direction of the input radiation beam 127 to be used as part of a feedback alignment process for aligning an input radiation beam 127 with an amplification cavity 106, as now discussed with reference to Figure 5. Figure 5 shows the first measurement system 122 and the amplification cavity 106 (for ease of understanding some parts of the first measurement system 122 are not shown).

The first measurement system 122 also comprises two movable mirrors 154, 156 arranged to receive the input radiation beam 127 sequentially. In this embodiment, each of the movable mirrors is rotatable about two mutually orthogonal axes. The two movable mirrors 154, 156 may be considered to provide steering optics, the steering optics being arranged to receive the input radiation beam 127 and to direct the input radiation beam 127 to the beam splitter 126. Since each of the two movable mirrors 154, 156 is rotatable about two mutually orthogonal axes, the steering optics may be considered to comprise an adjustment mechanism operable to control a direction and/or position of the input radiation beam 127 at the beam splitter 126. It will be appreciated that the steering optics may comprise any system of optics that allows a direction and/or position of the input radiation beam to be controlled.

Advantageously, such an arrangement allows a position and/or direction of the input radiation beam 127 that is input into a light amplification cavity to be optimized. The adjustment mechanism of the steering optics can be used (for example by rotating one or both of the two rotatable mirrors 154, 156) to control a direction and/or position of the input radiation beam 127 at the beam splitter 126. Simultaneously, the position and/or direction of the radiation beam 127 can be monitored using the first and second images 180, 182 that are formed on the detector 136. A user can therefore use the adjustment mechanism of the steering optics (i.e. can rotate the one or both of the two rotatable mirrors 154, 156) to align the input radiation beam 127 to the amplification cavity 106. For example, the user may rotate one or both of the two rotatable mirrors 154, 156 so as to control the position and/or direction of the input radiation beam until the first and second images 180, 182 have desired positions and/or shapes.

In some embodiments, the first measurement system 122 may further comprise a display (for example a screen or monitor or the like) for displaying the images formed on the detector 136 (of the input radiation beam 127 in two different axially spaced planes along the first optical path). This may provide a useful visual guide for a user performing an alignment process.

In some embodiments, the first measurement system 122 may further comprise a memory operable to store information about a nominal direction and/or nominal position of an input radiation beam 127. For example, the memory may store information about the first and second images that would be formed when the input radiation beam 127 is pointing in the nominal direction and/or is at the nominal position. The memory may store the first and second images that would be formed when the input radiation beam 127 is pointing in the nominal direction and/or is at the nominal position. Additionally or alternatively, the memory may store information about these first and second images such as, for example, central positions thereof.

In some embodiments, the first measurement system 122 may further comprise a feedback loop operable to use the adjustment mechanism of the steering optics (i.e. the positions of the two rotatable mirrors 154, 156) to control the position and/or direction of the input radiation beam 127 until the position and/or direction of the input radiation beam 127 substantially coincide with the nominal direction and/or nominal position of an input radiation beam. Such an arrangement may, advantageously, allow an alignment process for a light amplification cavity to be substantially automated.

The display may be operable to display at least one visual marker for each of the first and second images 180, 182. The at least one visual marker may be indicative of a position and/or shape of that one of the first and second images 180, 182 when the position and/or direction of the input radiation beam 127 substantially coincides with the nominal direction and/or nominal position of an input radiation beam 127. For example, a marker (for example a cross) may be displayed on the display to indicate a desired or nominal position of a center of each of the first and second images 180, 182. A user can use the adjustment mechanism of the steering optics (i.e. can control the orientation of the two rotatable mirrors 154, 156) to control the position and/or direction of the input radiation beam 127 until the center of each of the first and second images 180, 182 coincides with one of said markers. Alternatively, a marker (for example a circle) may be displayed on the display to indicate a desired or nominal position of an edge portion of each of the first and second images 180, 182. A user can use the adjustment mechanism of the steering optics (i.e. can control the orientation of the two rotatable mirrors 154, 156) to control the position and/or direction of the input radiation beam 127 until the edge portion of each of the first and second images 180, 182 coincides with one of said markers.

Although the optical system that forms two images 180, 182 of the input radiation beam 127 in two different planes comprises the first and second lenses 132, 134 described above. It will be appreciated that in alternative examples this imaging system may comprise any system of optics that is operable to split the radiation beam into two parts and form the first and second images 180, 182 from said two parts. However, the use of the second lens 134 in particular provides an advantageous arrangement for a number of reasons, as now discussed.

First, the second lens 134 is a single component that is operable to both: (a) split the incident radiation into two parts (the first and second transmitted portions 150, 152); and (b) focus said portions with different focal lengths (so as to image the two different images 180, 182).

As described above, the reflectivity R of the reflective coating on the first and second surfaces 146, 148 determines the relative intensities of the first and second transmitted portions 150, 152. Furthermore, the radius of curvature of the first and second surfaces 146, 148 determines (along with the focal length of the first lens 132) the focal length of the imaging system experienced by the first and second transmitted portions 150, 152. Equivalently, the radius of curvature of the first and second surfaces 146, 148 (along with the focal length of the first lens 132) determines the size of the two images 180, 182 formed on the detector 136. Note that the focal length of the first lens 132 is the same for both the first and second transmitted portions 150, 152. In contrast, the focal length of the second lens 134 is different for the first and second transmitted portions 150, 152.

In some embodiments, the reflectivity R of the reflective coating on the first and second surfaces 146, 148 and the radii of curvature of the first and second surfaces 146, 148 are selected so as to ensure that the intensity densities of the two images 180, 182 are substantially matched. For example, the intensity of the first transmitted portion 150 is proportional to (1-R)² and the intensity of the second transmitted portion 152 is proportional to R²(1-R)², such that the ratio of the intensity of the second transmitted portion 152 to the first transmitted portion 150 is R². For R=1/3, the intensity of the second transmitted portion 152 will be a factor of 9 smaller than the intensity of the first transmitted portion 150. The radii of curvature of the first and second surfaces 146, 148 may therefore be selected such that the area of the first image 180 is a factor of 9 bigger than the area of the second image 182. Equivalently, the radii of curvature of the first and second surfaces 146, 148 may be selected such that the diameter of the first image 180 is a factor of 3 bigger than the diameter of the second image 182. In general, it may be desirable to ensure that the ratio of the diameter of the second image 182 to the diameter of the first image 180 is R. By doing this, it can be ensured that both of the first and second images 180, 182 are matched to a dynamic range of the detector 136.

The second measurement system 124 in Figure 3 will now be described. The second measurement system 124 shares several features in common with the first measurement system 122 described above. Where features are generally equivalent they share common reference numerals. Only the differences between the second measurement system 124 and the first measurement system 122 are described in detail below.

The second measurement system 124 is provided at an end of the amplification cavity 106 which receives the output of the pre-pulse seed laser 104 and the second pass of the output of the main pulse seed laser 102.

The second measurement system 124 does not have the optional polarizer 144 of the first measurement system 122. Instead, the second measurement system 124 comprises a dichroic mirror 158. The dichroic mirror is arranged to have a lower transmittance for the output of the main pulse seed laser 102 and the output of the pre-pulse seed laser 104. In particular, the dichroic mirror 158 may be arranged to at least partially attenuate the main pulse beam such that it is reduced in intensity to a similar level to the intensity of the pre-pulse beam. Note that although the dichroic mirror 158 may partially attenuate the main pulse beam it may be that there is no significant attenuation of the pre-pulse beam by the dichroic mirror 158. In this way, it can be ensured that images of both the pre-pulse beam and the main pulse beam can be matched to a dynamic range of the detector 136.

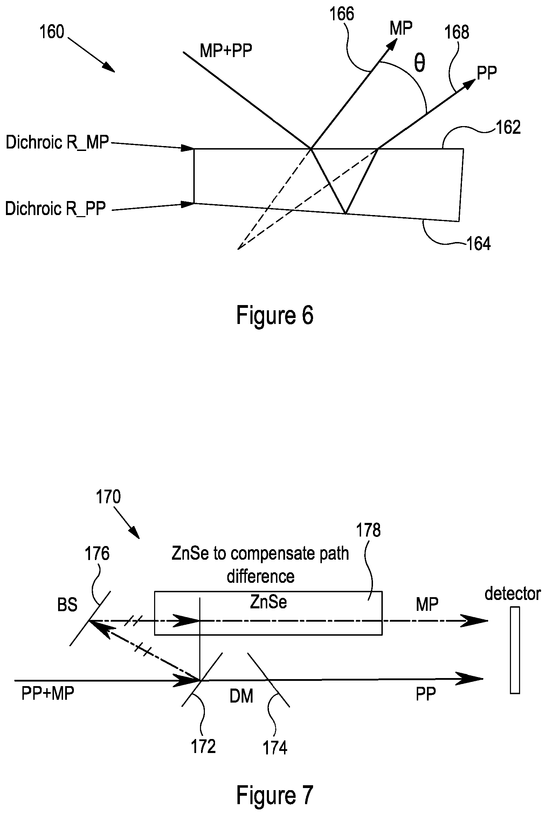

In addition, the first mirror 138 downstream of the second lens 134 in the first measurement system 122 has been replaced by a novel dichroic wedge 160. The dichroic wedge 160 is now described with reference to Figure 6.

The dichroic wedge 160 is an optical element comprising first and second opposed surfaces 162, 164. The first and second opposed surfaces 162, 164 are arranged at a non-zero angle to each other. The first surface 162 is provided with a coating that is reflective for a first wavelength of radiation (for example the main pulse laser) and transmissive for a second wavelength of radiation (for example the pre-pulse laser). The second surface 164 is reflective for the second wavelength of radiation (for example the pre-pulse laser). For example, this reflection may be as a result of reflection at the interface between the second surface 164 of the dichroic wedge 160 and a surrounding medium. Optionally, the second surface 164 may be provided with a coating that is reflective for the second wavelength of radiation (for example the pre-pulse laser). Optionally, the coating that is provided on the second surface 164 may also be transmissive for the first wavelength of radiation (for example the main pulse laser).

In use, the dichroic wedge 160 is disposed so as to receive an input radiation beam (from the second lens 134) comprising a mixture of the first wavelength and the second wavelength (for example a mixture of the pre-pulse and the main pulse radiation). This mixture is, in general, incident on the first surface 162 at a non-zero angle of incidence. Since the first and second opposed surfaces 162, 164 are arranged at a non-zero angle to each other and since the first and second opposed surfaces 162, 164 reflect and transmit the two wavelength components differently, the dichroic wedge 160 is operable to direct the first and second wavelength components to separate locations.

In particular, upon incidence on the first surface 162 the first wavelength of radiation (for example the main pulse laser) is reflected so as to form a first output beam 166. The second wavelength of radiation (for example the pre-pulse laser) is transmitted and propagates through the dichroic wedge 160. The second wavelength of radiation is then incident on the second surface 164 and is reflected so as to form a second output beam 168, which is transmitted by the first surface 162. Note that any portions of the first wavelength of radiation that are transmitted by the first surface 162 will tend to be transmitted by the second surface 164 and so prevented from forming part of the second output beam 168. Furthermore, any portion of the first wavelength of radiation that is transmitted by the first surface 162 and then reflected by the second surface 164 will tend then to be reflected by the first surface 162 (back into the dichroic wedge 160) and so also prevented from forming part of the second output beam 168. Since the first and second opposed surfaces 162, 164 are arranged at a non-zero angle θ to each other, the first and second output beams 166, 168 diverge and, in the far field, will be spatially separated from each other.

The dichroic wedge is configured to split an input radiation beam into at least two wavelength components and to direct said at least two components to different portions of the detector 136. For example, the input radiation beam may comprise two different wavelengths of radiation. Said two different wavelengths of radiation may both be directed into the amplification cavity 106.

It will be appreciated that each of the at least two wavelength components may be provided with separate steering optics, of the type described above (and comprising separate adjustment mechanisms operable to control a direction and/or position of each of the at least two wavelength components of the input radiation beam).

Figure 3B shows an example of the four images 186, 188, 190, 192 formed in the image plane 194 in which the detector 136 of the second measurement system 124 is disposed.

As explained above, the second lens 134 serves to split an incoming radiation beam into two spatially separated portions (first transmitted portion 150 and second transmitted portion 152) of the detector 136. The dichroic wedge 160 splits each of these further into two portions (a pre-pulse portion and a main pulse portion). It will be appreciated that the dichroic wedge 160 splits the radiation in different (for example orthogonal) direction to the splitting that is performed by the second lens 134. As explained above, the second lens 134 splits the incoming radiation beam into two portions (the first transmitted portion 150 and second transmitted portion 152) that are spatially separated in the y-direction. The dichroic wedge 160 splits each of these further into two portions (a pre-pulse portion and a main pulse portion) which are spatially separated in the x-direction.

As a result, four images 186, 188, 190, 192 are formed in the image plane 194 of the detector 136: first and second images 186, 188 for the pre-pulse radiation and first and second images 190, 192 for the main pulse radiation.

The dichroic wedge 160 is particularly advantageous since it can perform multiple functions and therefore save space. As shown in Figure 7, an alternative chromatic optics 170 may, for example, comprise two dichromic mirrors 172, 174, a beam splitter 176 and an optical component 178 to ensure that the two wavelength components travel an equal optical path length (such that the same two planes are imaged for the main pulse radiation and the pre-pulse radiation). The dichroic wedge 160 can perform these multiple functions and therefore save space.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A measurement system (122, 124) for use with a light amplification cavity (106), the measurement system comprising:
an input optical element (126) for receiving an input radiation beam (127) and directing: a first portion of the input radiation beam (128) along a first optical path; and a second portion of the input radiation beam (130) along a second optical path;
an imaging system arranged on the first optical path and configured to form in an image plane (184, 194): first and second images (180, 182, 186, 188, 190, 192) of the first portion of the input radiation beam, the first and second images being of two different axially spaced planes along the first optical path; and
a detector (136) disposed in the image plane and operable to detect the first and second images, **characterized in that** the imaging system comprises a lens (134) having two surfaces (146, 148) which are each provided with a reflective coating, at least one of said two surfaces being curved, and wherein the second portion of the input radiation beam is incident on the lens off-axis and wherein the first and second images are formed from separate portions of the second portion of the input radiation beam, the separate portions experiencing a different number of reflections from the two surfaces.

2. The measurement system of claim 1, further comprising steering optics (154, 156), the steering optics being arranged to receive the input radiation beam and to direct the input radiation beam to the input optical element, wherein the steering optics comprises an adjustment mechanism operable to control a direction and/or position of the input radiation beam at the input optical element.

3. The measurement system of claim 2 further comprising a feedback loop operable to use the adjustment mechanism of the steering optics to control the position and/or direction of the input radiation beam until the position and/or direction of the input radiation beam substantially coincide with the nominal direction and/or nominal position of the input radiation beam.

4. The measurement system of any preceding claim wherein the first image is formed from a first transmitted portion (150) of the radiation incident on the lens which is transmitted at both the first and the second surfaces of the lens; and wherein the second image is formed from a second transmitted portion (152) of the radiation incident on the lens which is transmitted at the first surface, internally reflected at the second surface, internally reflected at the first surface and then transmitted at the second surface.

5. The measurement system of claim 4 wherein the radii of curvature of the first and second surfaces are such that a diameter of the first image in the image plane is bigger than a diameter of the second image in the image plane.

6. The measurement system of claim 5 wherein the first and second surfaces have a reflectivity of R and wherein the radii of curvature of the first and second surfaces are such that the diameter of the first image in the image plane is bigger than the diameter of the second image in the image plane by a factor of R.

7. The measurement system of any one of claims 4 to 5 wherein the reflectivities of the reflective coatings on the first and second surfaces of the lens and the radii of curvature of the first and second surfaces of the lens are such that the intensity densities of the two images are substantially matched.

8. The measurement system of any preceding claim, further comprising chromatic optics (160) arranged on the first optical path and configured to split the input radiation beam into at least two wavelength components and to direct said at least two components to different portions of the detector.

9. The measurement system of claim 8 wherein the chromatic optics comprises an optical element comprising first and second opposed surfaces (162, 164), the first and second opposed surfaces arranged at a non-zero angle to each other;
wherein the first surface is provided with a coating that is reflective for a first wavelength of radiation and transmissive for a second wavelength of radiation; and
wherein the second surface is reflective for the second wavelength of radiation.

10. The measurement system of claim 9 wherein the second surface of the optical element is provided with a coating that is reflective for the second wavelength of radiation.

11. A system comprising:
an amplification cavity;
the measurement system of any preceding claim, wherein the amplification cavity is arranged along the second optical path.

12. The system of claim 11 wherein the amplification cavity comprises:
two coaxial generally cylindrical electrodes;
a gain medium provided in a generally tube shaped cavity defined between the two coaxial generally cylindrical electrodes; and
a generally annular mirror disposed at each end of the amplification cavity.

13. The system of claim 11 or claim 12, the system further comprising:
a seed laser operable to output a seed laser beam, the input optical element being arranged to receive the seed laser beam as the input radiation beam.

14. A laser produced plasma radiation source comprising:
a fuel emitter operable to produce a fuel target at a plasma formation region; and
a laser system comprising the system of any one of claims 11 to 13 arranged to irradiate the fuel target at the plasma formation region so as to produce a plasma.

## Patentansprüche

1. Ein Messsystem (122, 124) zur Verwendung mit einem Lichtverstärkungshohlraum (106), wobei das Messsystem Folgendes beinhaltet:
ein optisches Eingangselement (126) zum Empfangen eines Eingangsstrahlungsstrahls (127) und zum Richten: eines ersten Teils des Eingangsstrahlungsstrahls (128) entlang eines ersten optischen Wegs; und eines zweiten Teils des Eingangsstrahlungsstrahls (130) entlang eines zweiten optischen Wegs;
ein Abbildungssystem, das auf dem ersten optischen Weg eingerichtet ist und konfiguriert ist, um in einer Bildebene (184, 194) Folgendes zu bilden: ein erstes und ein zweites Bild (180, 182, 186, 188, 190, 192) des ersten Teils des Eingangsstrahlungsstrahls, wobei das erste und das zweite Bild von zwei unterschiedlichen, axial beabstandeten Ebenen entlang des ersten optischen Wegs herrühren; und
einen Detektor (136), der in der Bildebene angeordnet ist und betriebsfähig ist, das erste und das zweite Bild zu erfassen, **dadurch gekennzeichnet, dass** das Abbildungssystem eine Linse (134) beinhaltet, die zwei Oberflächen (146, 148) aufweist, welche jeweils mit einer reflektierenden Beschichtung versehen sind, wobei mindestens eine der zwei Oberflächen gekrümmt ist, und wobei der zweite Teil des Eingangsstrahlungsstrahls außeraxial auf die Linse einfällt und wobei das erste und das zweite Bild von separaten Teilen des zweiten Teils des Eingangsstrahlungsstrahls gebildet werden, wobei die separaten Teile eine unterschiedliche Anzahl von Reflexionen an den zwei Oberflächen erfahren.

2. Messsystem gemäß Anspruch 1, das ferner eine Lenkoptik (154, 156) beinhaltet, wobei die Lenkoptik eingerichtet ist, um den Eingangsstrahlungsstrahl zu empfangen und den Eingangsstrahlungsstrahl auf das optische Eingangselement zu richten, wobei die Lenkoptik einen Einstellungsmechanismus beinhaltet, der betriebsfähig ist, eine Richtung und/oder eine Position des Eingangsstrahlungsstrahls an dem optischen Eingangselement zu steuern.

3. Messsystem gemäß Anspruch 2, das ferner eine Rückkopplungsschleife beinhaltet, die betriebsfähig ist, den Einstellungsmechanismus der Lenkoptik zu verwenden, um die Position und/oder die Richtung des Eingangsstrahlungsstrahls zu steuern, bis sich die Position und/oder die Richtung des Eingangsstrahlungsstrahls im Wesentlichen mit der nominalen Richtung und/oder der nominalen Position des Eingangsstrahlungsstrahls decken.

4. Messsystem gemäß einem der vorhergehenden Ansprüche, wobei das erste Bild von einem ersten durchgelassenen Teil (150) der auf die Linse einfallenden Strahlung, der sowohl an der ersten als auch an der zweiten Oberfläche der Linse durchgelassen wird, gebildet wird; und wobei das zweite Bild von einem zweiten durchgelassenen Teil (152) der auf die Linse einfallenden Strahlung, der an der ersten Oberfläche durchgelassen, intern an der zweiten Oberfläche reflektiert, intern an der ersten Oberfläche reflektiert und dann an der zweiten Oberfläche durchgelassen wird, gebildet wird.

5. Messsystem gemäß Anspruch 4, wobei die Krümmungsradien der ersten und der zweiten Oberfläche derart sind, dass ein Durchmesser des ersten Bilds in der Bildebene größer als ein Durchmesser des zweiten Bilds in der Bildebene ist.

6. Messsystem gemäß Anspruch 5, wobei die erste und die zweite Oberfläche ein Reflexionsvermögen R aufweisen und wobei die Krümmungsradien der ersten und der zweiten Oberfläche derart sind, dass der Durchmesser des ersten Bilds in der Bildebene um einen Faktor R größer als der Durchmesser des zweiten Bilds in der Bildebene ist.

7. Messsystem gemäß einem der Ansprüche 4 bis 5, wobei die Reflexionsvermögen der reflektierenden Beschichtungen auf der ersten und der zweiten Oberfläche der Linse und die Krümmungsradien der ersten und der zweiten Oberfläche der Linse derart sind, dass die Intensitätsdichten der zwei Bilder im Wesentlichen übereinstimmen.

8. Messsystem gemäß einem der vorhergehenden Ansprüche, das ferner eine chromatische Optik (160) beinhaltet, die auf dem ersten optischen Weg eingerichtet ist und konfiguriert ist, um den Eingangsstrahlungsstrahl in mindestens zwei Wellenlängenkomponenten zu teilen und die mindestens zwei Komponenten auf unterschiedliche Teile des Detektors zu richten.

9. Messsystem gemäß Anspruch 8, wobei die chromatische Optik ein optisches Element beinhaltet, das eine erste und eine zweite gegenüberliegende Oberfläche (162, 164) beinhaltet, wobei die erste und die zweite gegenüberliegende Oberfläche in einem von Null verschiedenem Winkel zueinander eingerichtet sind;
wobei die erste Oberfläche mit einer Beschichtung versehen ist, die für eine erste Wellenlänge von Strahlung reflektierend ist und für eine zweite Wellenlänge von Strahlung durchlässig ist; und
wobei die zweite Oberfläche für die zweite Wellenlänge von Strahlung reflektierend ist.

10. Messsystem gemäß Anspruch 9, wobei die zweite Oberfläche des optischen Elements mit einer Beschichtung versehen ist, die für die zweite Wellenlänge von Strahlung reflektierend ist.

11. Ein System, das Folgendes beinhaltet:
einen Verstärkungshohlraum;
das Messsystem gemäß einem der vorhergehenden Ansprüche, wobei der Verstärkungshohlraum entlang des zweiten optischen Wegs eingerichtet ist.

12. System gemäß Anspruch 11, wobei der Verstärkungshohlraum Folgendes beinhaltet:
zwei koaxiale, im Allgemeinen zylindrische Elektroden;
ein Verstärkungsmedium, das in einem im Allgemeinen röhrenförmigen Hohlraum, der zwischen den zwei koaxialen, im Allgemeinen zylindrischen Elektroden definiert ist, bereitgestellt ist; und
einen im Allgemeinen ringförmigen Spiegel, der an jedem Ende des Verstärkungshohlraums angeordnet ist.

13. System gemäß Anspruch 11 oder Anspruch 12, wobei das System ferner Folgendes beinhaltet:
einen Seed-Laser, der betriebsfähig ist, einen Seed-Laserstrahl auszugeben, wobei das optische Eingangselement eingerichtet ist, um den Seed-Laserstrahl als den Eingangsstrahlungsstrahl zu empfangen.

14. Eine Strahlungsquelle mit lasererzeugtem Plasma, die Folgendes beinhaltet:
einen Brennstoffemitter, der betriebsfähig ist, ein Brennstoffziel in einer Plasmabildungsregion zu erzeugen; und
ein Lasersystem, das das System gemäß einem der Ansprüche 11 bis 13 beinhaltet, eingerichtet, um das Brennstoffziel in der Plasmabildungsregion zu bestrahlen, um ein Plasma zu erzeugen.

## Revendications

1. Un système de mesure (122, 124) pour son utilisation avec une cavité d'amplification de lumière (106), le système de mesure comprenant :
un élément optique d'entrée (126) pour recevoir un faisceau de rayonnement d'entrée (127) et diriger : une première portion du faisceau de rayonnement d'entrée (128) le long d'un premier chemin optique ; et une deuxième portion du faisceau de rayonnement d'entrée (130) le long d'un deuxième chemin optique ;
un système d'imagerie agencé sur le premier chemin optique et configuré afin de former dans un plan image (184, 194) : des première et deuxième images (180, 182, 186, 188, 190, 192) de la première portion du faisceau de rayonnement d'entrée, les première et deuxième images étant de deux plans différents espacés axialement le long du premier chemin optique ; et
un détecteur (136) disposé dans le plan image et opérationnel afin de détecter les première et deuxième images, **caractérisé en ce que** le système d'imagerie comprend une lentille (134) ayant deux surfaces (146, 148) qui sont chacune pourvues d'un revêtement réfléchissant, au moins l'une desdites deux surfaces étant courbe, et dans lequel la deuxième portion du faisceau de rayonnement d'entrée est incidente sur la lentille hors axe et dans lequel les première et deuxième images sont formées à partir de portions séparées de la deuxième portion du faisceau de rayonnement d'entrée, les portions séparées connaissant un nombre différent de réflexions depuis les deux surfaces.

2. Le système de mesure de la revendication 1, comprenant en sus une optique d'orientation (154, 156), l'optique d'orientation étant agencée afin de recevoir le faisceau de rayonnement d'entrée et de diriger le faisceau de rayonnement d'entrée vers l'élément optique d'entrée, dans lequel l'optique d'orientation comprend un mécanisme d'ajustement opérationnel pour contrôler une direction et/ou une position du faisceau de rayonnement d'entrée au niveau de l'élément optique d'entrée.

3. Le système de mesure de la revendication 2 comprenant en sus une boucle d'asservissement opérationnelle pour utiliser le mécanisme d'ajustement de l'optique d'orientation afin de contrôler la position et/ou la direction du faisceau de rayonnement d'entrée jusqu'à ce que la position et/ou la direction du faisceau de rayonnement d'entrée coïncident substantiellement avec la direction nominale et/ou la position nominale du faisceau de rayonnement d'entrée.

4. Le système de mesure de n'importe quelle revendication précédente dans lequel la première image est formée à partir d'une première portion transmise (150) du rayonnement incident sur la lentille qui est transmise au niveau de l'une et l'autre des première et deuxième surfaces de la lentille ; et dans lequel la deuxième image est formée à partir d'une deuxième portion transmise (152) du rayonnement incident sur la lentille qui est transmise au niveau de la première surface, réfléchie de manière interne au niveau de la deuxième surface, réfléchie de manière interne au niveau de la première surface et transmise ensuite au niveau de la deuxième surface.

5. Le système de mesure de la revendication 4 dans lequel les rayons de courbure des première et deuxième surfaces sont tels qu'un diamètre de la première image dans le plan image est plus grand qu'un diamètre de la deuxième image dans le plan image.

6. Le système de mesure de la revendication 5 dans lequel les première et deuxième surfaces ont une réflectivité de R et dans lequel les rayons de courbure des première et deuxième surfaces sont tels que le diamètre de la première image dans le plan image est plus grand que le diamètre de la deuxième image dans le plan image par un facteur de R.

7. Le système de mesure de n'importe laquelle des revendications 4 à 5 dans lequel les réflectivités des revêtements réfléchissants sur les première et deuxième surfaces de la lentille et les rayons de courbure des première et deuxième surfaces de la lentille sont tels que les densités d'intensité des deux images sont substantiellement concordantes.

8. Le système de mesure de n'importe quelle revendication précédente, comprenant en sus une optique chromatique (160) agencée sur le premier chemin optique et configurée afin de diviser le faisceau de rayonnement d'entrée en au moins deux composantes de longueur d'onde et de diriger lesdites au moins deux composantes vers différentes portions du détecteur.

9. Le système de mesure de la revendication 8 dans lequel l'optique chromatique comprend un élément optique comprenant des première et deuxième surfaces opposées (162, 164), les première et deuxième surfaces opposées étant agencées à un angle non nul l'une par rapport à l'autre ;
dans lequel la première surface est pourvue d'un revêtement qui est réfléchissant pour une première longueur d'onde de rayonnement et transmissif pour une deuxième longueur d'onde de rayonnement ; et
dans lequel la deuxième surface est réfléchissante pour la deuxième longueur d'onde de rayonnement.

10. Le système de mesure de la revendication 9 dans lequel la deuxième surface de l'élément optique est pourvue d'un revêtement qui est réfléchissant pour la deuxième longueur d'onde de rayonnement.

11. Un système comprenant :
une cavité d'amplification ;
le système de mesure de n'importe quelle revendication précédente, dans lequel la cavité d'amplification est agencée le long du deuxième chemin optique.

12. Le système de la revendication 11, dans lequel la cavité d'amplification comprend :
deux électrodes coaxiales généralement cylindriques ;
un milieu de gain fourni dans une cavité généralement en forme de tube définie entre les deux électrodes coaxiales généralement cylindriques ; et
un miroir généralement annulaire disposé au niveau de chaque extrémité de la cavité d'amplification.

13. Le système de la revendication 11 ou de la revendication 12, le système comprenant en sus :
un laser germe *(seed laser)* opérationnel afin de délivrer en sortie un faisceau laser germe, l'élément optique d'entrée étant agencé afin de recevoir le faisceau laser germe en tant que faisceau de rayonnement d'entrée.

14. Une source de rayonnement plasma produit par laser comprenant :
un émetteur de combustible opérationnel afin de produire une cible combustible au niveau d'une région de formation de plasma ; et
un système de laser comprenant le système de n'importe laquelle des revendications 11 à 13 agencé afin d'irradier la cible combustible au niveau de la région de formation de plasma de manière à produire un plasma.
